# EUROPEAN PATENT APPLICATION

(11) **EP 1 732 150 A1**
(43) Date of publication of application: **13.12.2006**
(21) Application number: 06115050.4
(22) Date of filing: 07.06.2006
(51) Int. Cl.: H01L 51/10

(54) **Organic thin film transistors with multilayer electrodes**

(30) Priority: 07.06.2005 US 146705
(71) Applicant: Xerox Corporation, Rochester, NY 14644 (US)
(72) Inventor: Wu, Yiliang, Mississauga Ontario L5M 7K3 (CA); Ong, Beng S., Mississauga Ontario L5L 4V9 (CA)
(74) Representative: Grünecker, Kinkeldey, Stockmair & Schwanhäusser Anwaltssozietät

(57) **Abstract**

An thin-film transistor (TFT) with multilayer source and drain electrodes is provided. Each source and drain electrode comprises a first layer of a first conductive material and a second layer of a conductive polymer which has a work function identical or similar to that of the semiconductor layer. The second layer is in contact with the semiconductor layer.

## Description

### BACKGROUND

The present disclosure relates, in various embodiments, to multilayer electrodes and thin-film transistors (TFTs) comprising the same.

TFTs are fundamental components in modern-age electronics, including, for example, sensor, imaging, and display devices. TFT circuits using current mainstream silicon technology may be too costly for some applications, particularly for large-area electronic devices such as backplane switching circuits for displays (e.g., active matrix liquid crystal monitors or televisions) where high switching speeds are not essential. The high costs of silicon-based TFT circuits are primarily due to the capital-intensive silicon fabrications as well as the complex high-temperature, high-vacuum photolithographic fabrication processes under strictly controlled environments needed to make them. Because of the cost and complexity of fabricating silicon-based TFT circuits using conventional photolithography processes, there has been an increased interest in organic TFTs (OTFTs). Organic materials offer not only the possibility of using low-cost solution or liquid fabrication techniques, but also attractive mechanical properties such as being physically compact, lightweight, and flexible.

OTFTs are generally composed of, on a substrate, an electrically conductive gate, source and drain electrodes, an electrically insulating gate dielectric layer which separated the gate electrode from the source and drain electrodes, and a semiconducting layer which is in contact with the gate dielectric layer and bridges the source and drain electrodes. The material used to make the source and drain electrodes will affect the performance of the OTFTs. The material should have a work function identical or very close to the highest occupied molecular orbital (HOMO) of the semiconductor in the case of p-type semiconductor or the lowest unoccupied molecular orbital (LUMO) of the semiconductor in the case of n-type semiconductor so that there will be no energy barrier for charge injection and extraction. The energy barrier can be deduced by measuring the contact resistance between the electrodes and the semiconductor. For optimum operation, low or no contact resistance is desired. If contact resistance is high, then high electrical field strengths are necessary at the electrodes in order to inject and extract charge carriers.

Several materials have been tested for use in the source and drain electrodes. Conductive polymers are mechanically and electrically compatible with organic semiconductors and generally form ohmic contact so there is no or low contact resistance. However, they generally have low electrical conductivities; for example, commercially available PEDOT doped with PSS has an electrical conductivity of 10⁻¹ Siemens per centimeter (S/cm). Noble metals such as gold and platinum are highly conductive and have a work function compatible with the semiconductor layer. However, these metals are also very expensive and are not suitable for low-cost large-area devices. Other metals, such as copper and aluminum, are cheaper, but have a work function which does not match the HOMO level of most p-type organic semiconductors. As a result, when these metals are used as the source and drain electrodes with p-type semiconductor, OTFTs usually show high contact resistance, thus poor performance.

### BRIEF DESCRIPTION

The present disclosure relates, through various exemplary embodiments, to TFTs. The TFT comprises a substrate, a gate electrode, a source electrode, a drain electrode, a dielectric layer and a semiconductor layer. The source and drain electrodes comprise first and second layers and the source electrode second layer is in direct contact with the semiconductor layer.

In further embodiments of the present disclosure, the TFTs are organic TFTs, wherein the semiconductor layer is an organic semiconductor layer.

Additionally, the present disclosure provides a new device and structure to balance the electrical requirements of the source and drain electrodes with economical materials for use in a low-cost large-area device. An electrode with a multilayer structure is disclosed which is useful in an OTFT. The multilayer structure comprises at least a first layer comprising a material with high conductivity and a second layer comprising a material having a work function identical or similar to the energy level of the semiconductor layer. The second layer lies between the first layer and the semiconductor layer.

In further embodiments of the present disclosure, the first layer is a metal comprising the core of the electrode. The second layer is an organic conductive polymer which covers the core's surface and is in contact with the semiconductor layer. The metal provides high conductivity while the organic conductive polymer provides electrical compatibility with the semiconductor layer.

In a still further embodiment of the present disclosure, an OTFT with multilayer source and drain electrodes is provided. Each source and drain electrode comprises a first layer of a first conductive material and a second layer of a conductive polymer which has a work function identical or similar to that of the organic semiconductor layer. The second layer is in contact with the organic semiconductor layer.
In one embodiment of the thin-film transistor of claim 1, the source electrode second layer and the drain electrode second layer each have a thickness of up to about 3000 nanometers.
In a further embodiment the source electrode second layer and the drain electrode second layer each have a thickness of from about 50 to about 1000 nanometers.
In a further embodiment the source electrode first layer and the drain electrode first layer each have a conductivity greater than 10 S/cm.
In a further embodiment the source electrode second layer and the drain electrode second layer each have a conductivity greater than 10⁻⁴ S/cm.
In a further embodiment the difference in work function between the organic semiconductor layer and the source electrode second layer is less than 1.0 eV.
In a further embodiment the difference in work function between the organic semiconductor layer and the source electrode second layer is less than 0.5 eV.
In a further embodiment the source electrode first layer, the drain electrode first layer, the source electrode second layer, and the drain electrode second layer are all electrically conductive.
In a further embodiment the semiconductor is a p-type semiconductor.
In one embodiment of the organic thin-film transistor of claim 9, both the source electrode first layer and the drain electrode first layer are copper, both the source electrode second layer and the drain electrode second layer are PSS-PEDOT, and the organic semiconductor is a polythiophene.
In one embodiment of the processing of claim 10, the step of coating is performed by spin coating or dipping coating.

These and other non-limiting characteristics of the disclosure are more particularly disclosed below.

### BRIEF DESCRIPTION OF THE DRAWINGS

The following is a brief description of the drawings, which are presented for the purposes of illustrating the exemplary embodiments disclosed herein and not for the purposes of limiting the same.

FIGURE 1 represents a first embodiment of a TFT according to the present disclosure.

FIGURE 2 represents a second embodiment of a TFT according to the present disclosure.

FIGURE 3 represents a third embodiment of a TFT according to the present disclosure.

FIGURE 4 represents a fourth embodiment of a TFT according to the present disclosure.

FIGURE 5 represents a fifth embodiment of a TFT according to the present disclosure.

### DETAILED DESCRIPTION

This disclosure describes a TFT with multilayer source and drain electrodes. Each source and drain electrode comprises a first layer including a first conductive material and a second layer including a conductive polymer. In embodiments, the source electrode first layer may be the same as or different from the drain electrode first layer. The source electrode second layer may be the same as or different from the drain electrode second layer. In embodiments, the source electrode second layer is in contact with the semiconductor layer of the OTFT. Preferably, the source electrode second layer has a work function identical or similar to the HOMO or LUMO level of the semiconductor layer depending on whether it is p- or n-type semiconductor, respectively.

A more complete understanding of the components, processes and apparatuses disclosed herein can be obtained by reference to the accompanying drawings. These figures are merely schematic representations based on convenience and the ease of demonstrating the present disclosure, and are, therefore, not intended to indicate relative size and dimensions of the devices or components thereof and/or to define or limit the scope of the exemplary embodiments.

Although specific terms are used in the following description for the sake of clarity, these terms are intended to refer only to the particular structure of the embodiments selected for illustration in the drawings, and are not intended to define or limit the scope of the disclosure. In the drawings and the following description below, it is to be understood that like numeric designations refer to components of like function.

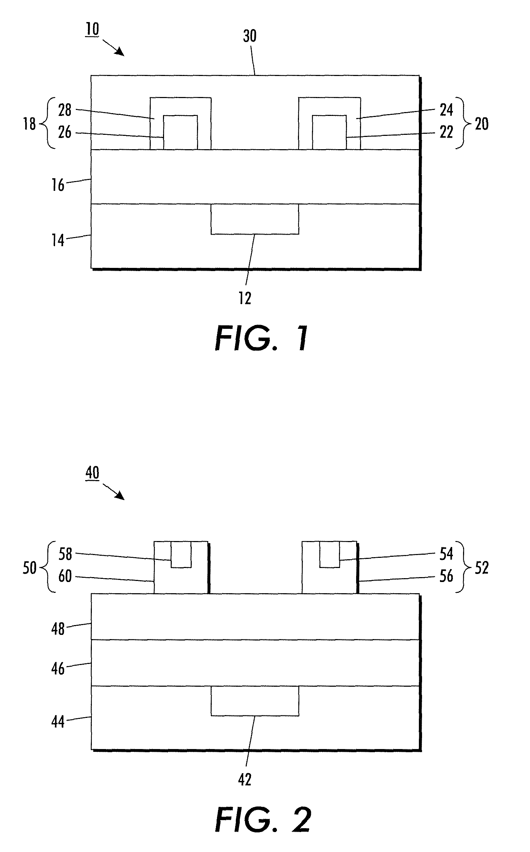

FIGURE 1 illustrates a TFT configuration according to the present disclosure. The TFT **10** comprises a substrate **14** in contact with the gate electrode **12** and a dielectric layer **16.** Although here the gate electrode **12** is depicted within the substrate **14,** this is not required; the key is that the dielectric layer **16** separates the gate electrode **12** from the source electrode **18,** drain electrode **20,** and the semiconductor layer **30.** The source electrode **18** comprises a first layer **26** contacting the dielectric layer **16** and a second layer **28** contacting the semiconductor layer **30.** The drain electrode **20** also comprises a first layer **22** contacting the dielectric layer **16** and a second layer **24** contacting the semiconductor layer **30.** The semiconductor layer **30** runs over and between the source and drain electrodes **18** and **20.**

FIGURE 2 illustrates another TFT configuration according to the present disclosure. The TFT 40 comprises a substrate 44 in contact with the gate electrode 42 and a dielectric layer 46. The semiconductor layer 48 is placed on top of the dielectric layer 46 and separates it from the source and drain electrodes 50 and 52. The source electrode 50 comprises a first layer 58 and a second layer 60. The drain electrode 52 also comprises a first layer 54 and a second layer 56. Note that only the second layers 60 and 56 of the source and drain electrodes 50 and 52 contact the semiconductor layer 48.

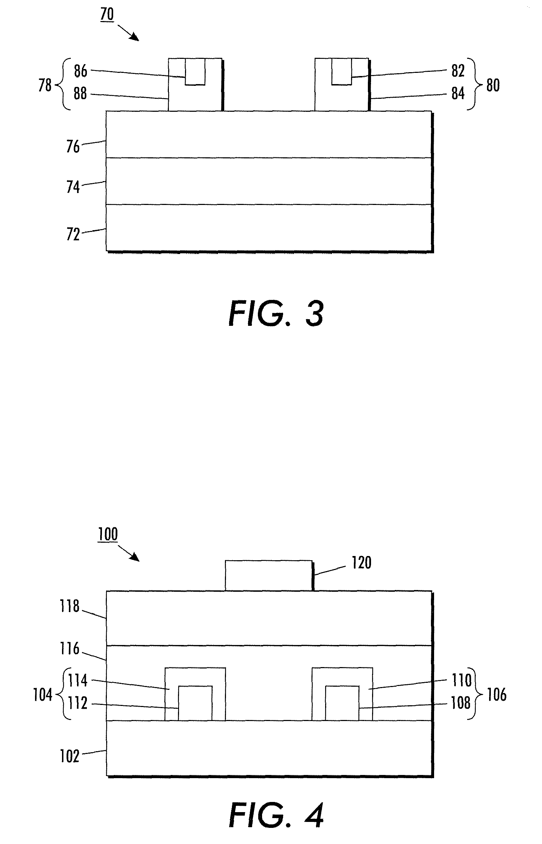

FIGURE 3 illustrates another TFT configuration according to the present disclosure. The TFT 70 comprises a substrate 72 which also acts as the gate electrode and is in contact with a dielectric layer 74. The semiconductor layer 76 is placed on top of the dielectric layer 74 and separates it from the source and drain electrodes 78 and 80. The source electrode 78 comprises a first layer 86 and a second layer 88. The drain electrode 80 also comprises a first layer 82 and a second layer 84. Note that only the second layers 88 and 84 of the source and drain electrodes 78 and 80 contact the semiconductor layer 76.

FIGURE 4 illustrates another TFT configuration according to the present disclosure. The TFT 100 comprises a substrate 102 in contact with the source electrode 104, drain electrode 106, and the semiconductor layer 116. The source electrode 104 comprises a first layer 112 contacting the substrate 102 and a second layer 114 contacting the semiconductor layer 116. The drain electrode 106 also comprises a first layer 108 contacting the substrate 102 and a second layer 110 contacting the semiconductor layer 116. The semiconductor layer 116 runs over and between the source and drain electrodes 104 and 106. The dielectric layer 118 is on top of the semiconductor layer 116. The gate electrode 120 is on top of the dielectric layer 118 and does not contact the semiconductor layer 116.

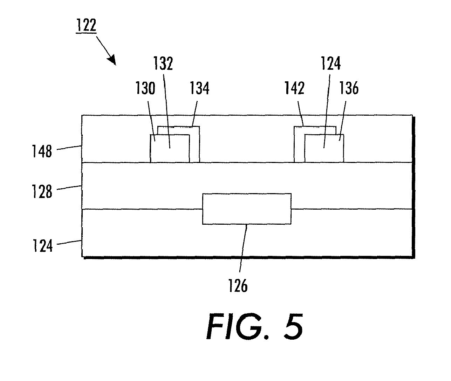

Figure 5 illustrates a further TFT configuration according to the present disclosure. The TFT 122 comprises a substrate 124 in contact with the gate electrode 126 and a dielectric layer 128. On top of the dielectric layer 128 are the source electrode 130 comprising a first layer 132 and a second layer 134, and the drain electrode **136** comprising a first layer **140** and a second layer **142.** The semiconductor **148** bridges the source and drain electrodes.

The substrate may be composed of materials including but not limited to silicon, glass plate, plastic film or sheet. For structurally flexible devices, plastic substrate, such as for example polyester, polycarbonate, polyimide sheets and the like may be preferred. The thickness of the substrate may be from about 10 micrometers to over 10 millimeters with an exemplary thickness being from about 50 to about 100 micrometers, especially for a flexible plastic substrate and from about 1 to about 10 millimeters for a rigid substrate such as glass or silicon.

The gate electrode is composed of an electrically conductive material. It can be a thin metal film, a conducting polymerfilm, a conducting film made from conducting ink or paste, or the substrate itself, for example heavily doped silicon. Examples of gate electrode materials include but are not restricted to aluminum, gold, chromium, indium tin oxide, conductive polymers such as polystyrene sulfonate-doped poly(3,4-ethylenedioxythiophene) (PSS-PEDOT), and conducting ink/paste comprised of carbon black/graphite. The gate electrode can be prepared by vacuum evaporation, sputtering of metals or conductive metal oxides, conventional lithography and etching, chemical vapor deposition, spin coating, casting or printing, or other deposition processes. The thickness of the gate electrode ranges for example from about 10 to about 200 nanometers for metal films and from about 1 to about 10 micrometers for conductive polymers.

The dielectric layer generally can be an inorganic material film or an organic polymer film. Examples of inorganic materials suitable as the dielectric layer include silicon oxide, silicon nitride, aluminum oxide, barium titanate, barium zirconium titanate and the like. Examples of suitable organic polymers include polyesters, polycarbonates, poly(vinyl phenol), polyimides, polystyrene, poly(methacrylate)s, poly(acrylate)s, epoxy resin and the like. The thickness of the dielectric layer depends on the dielectric constant of the material used and can be, for example, from about 5 nanometers to about 5000 nanometers, including from about 100 to about 1000 nanometers. The dielectric layer may have a conductivity that is, for example, less than about 10⁻¹² Siemens per centimeter (S/cm). The dielectric layer is formed using conventional processes known in the art, including those processes described in forming the gate electrode.

The semiconductor layer generally is an organic semiconducting material. Examples of organic semiconductors include but are not limited to acenes, such as anthracene, tetracene, pentacene, and substituted pentacenes, perylenes, fullerenes, oligothiophenes, polythiophenes and their substituted derivatives, polypyrrole, poly-p-phenylenes, poly-p-phenylvinylidenes, naphthalenedicarboxylic dianhydrides, naphthalene-bisimides, polynaphthalenes, phthalocyanines such as copper phthalocyanines or zinc phthalocyanines and their substituted derivatives. The semiconductor layer is from about 5 nanometers to about 1000 nanometers in thick, including from about 20 to about 100 nanometers in thick. In certain configurations, such as the configurations shown in FIGURES 1 and 5, the semiconductor layer completely covers the source and drain electrodes. The semiconductor layer can be formed by molecular beam deposition, vacuum evaporation, sublimation, spin-on coating, dip coating and other conventional processes known in the art, including those processes described in forming the gate electrode. In other embodiment, the semiconductor is an inorganic semiconductor such as ZnO, ZnS, silicon nanowires, and the like.

Regarding electrical performance characteristics, the organic semiconductor usually has a conductivity in the range of 10⁻⁸ to 10⁻⁴ S/cm. Various dopants known in the art may also be added to change the conductivity. The organic semiconductor can be either a p-type or n-type semiconductor. In embodiments, the semiconductor is a p-type semiconductor.

The source and drain electrodes are comprised of a first layer comprising a first conductive material and a second layer comprising a conductive polymer. The first conductive material has a conductivity for example greater than 0.1 S/cm, lager than 1 S/cm, greater than 10 S/cm, greater than 1000 S/cm, or greater than 10000 S/cm. The conductive polymer in the second layer has a conductive for example greater than 10⁻⁴ S/cm, greater than 10⁻² S/cm, greater than 0.1 S/cm, or greater than 10 S/cm. In embodiments, the first layer of the electrodes usually provides high conductivity, while the second layer of the electrodes matches the energy level of the semiconductor layer. The conductive polymer in the second layer of the electrodes should have a work function identical or very close to the HOMO or LUMO energy level of the semiconductor layer depending on whether it is p- or n-type semiconductor, respectively. For most p-type semiconductors, conductive polymers having a work function larger than 4.8 electron-volts (eV) are preferred. The difference in work function between the semiconductor layer and the conductive polymer of the second layer of the electrodes is less than for example 1.0 eV, less than for example 0.5 eV, or less than for example 0.2 eV.

In principle, any conductive material is suitable for the first layer of either the source or drain electrode. In embodiments, the first conductive materials is usually selected from, but not limited to, platinum, gold, silver, nickel, chromium, copper, iron, tin, antimony, lead, tantalum, indium, palladium, tellurium, rhenium, iridium, aluminum, ruthenium, germanium, molybdenum, tungsten, tin oxide-antimony, indium tin oxide, fluorine-doped zinc oxide, zinc, carbon, graphite, glassy carbon, silver paste, carbon paste, lithium, beryllium, sodium, magnesium, potassium, calcium, scandium, titanium, manganese, zirconium, gallium, niobium, sodium, sodium-potassium alloy, magnesium, and lithium. In further embodiments, the cheaper conductive materials are used; they are silver, nickel, chromium, copper, iron, tin, antimony, lead, tantalum, indium, aluminum, tungsten, tin oxide-antimony, indium tin oxide, fluorine-doped zinc oxide, zinc, carbon, graphite, silver paste, and carbon paste. The first layer can be from about 10 nanometers to 1000 nanometers thick, including from about 50 to about 500 nanometers thick, and can be formed by any deposition process known in the art, including those processes described in forming the gate electrode.

Any conductive polymer may be used in the second layer of either the source or drain electrode. In further embodiments, the conductive polymer is a polyaniline, polypyrrole, PSS-PEDOT, or their derivatives or their mixtures. These polymers may also be doped to enhance their conductivity. Generally, their conductivity is greater than 10⁻³ S/cm. The second layer can be from a monolayer of molecules to about 3000 nanometers thick, including from about 10 to about 1000 nanometers thick, and can be formed by any deposition process known in the art, including those processes described in forming the gate electrode.

The first layers of both the source and drain electrodes are preferably composed of the same material, as are the second layers. For example, the material chosen for the first layer of both the source and drain electrodes is copper and the material chosen for the second layer of both electrodes is PSS-PEDOT. However, the present disclosure also contemplates that the materials of both layers of either electrode are independently selected; for example, the first layer of the source electrode is copper, the second layer of the source electrode is a layer of PSS-PEDOT, the first layer of the drain electrode is aluminum, and the second layer of the drain electrode is a layer of polyaniline.

In embodiments, the first layer makes up the core of the electrode. In another embodiment, the second layer covers the core on all but one of its faces and separates the first layer from the semiconductor layer. The remaining face of the core can contact another component of the TFT. For example, the remaining face of the first layer is in contact with the dielectric layer in FIGURE 1 and in contact with the substrate in FIGURE 4. However, the remaining face does not need to contact another component of the TFT. For example, in FIGURES 2 and 3, it does not. In other embodiments, the second layer only covers part of the first layer, and both the second layer and the first layer of the electrodes are in contact with the semiconductor layer. For example, in FIGURE 5, it does.

In some embodiments, the second layer is deposited onto the first layer based on the difference in surface energy between the first layer of the electrodes and the surface on which the first layer of the electrodes is deposited. For example, the material of the first layer is chosen so that it has a high surface energy, while the surface or chemically modified surface, on which the first layer of the electrodes is deposited, is chosen so that it has a low surface energy. This allows the second layer of conductive polymer to be deposited, for example through a water-based dispersion. Because of the difference in surface energy, the second layer will fix only on the first layer and not the surface or chemically modified surface with low surface energy. The depositions may be performed, for example, by dip coating and spin coating. In other preferred embodiments, the second layer is deposited onto the first layer through *in situ* electrochemical polymerization of monomers of the conductive polymers. The first layer of the source and/or drain electrodes serves as the electrode in the electrochemical polymerization. By immersing a substrate with the first layer in a solution comprising a monomer of the conductive polymer, polymer is formed on the first layer by applying a voltage.

The various components of the OTFT may be deposited upon the substrate in any order. Generally, however, the gate electrode and the semiconductor layer should both be in contact with the dielectric layer. In addition, the source and drain electrodes should both be in contact with the semiconductor layer, particularly, the second layer of the electrodes should be in contact with the semiconductor layer.

The following examples are for purposes of further illustrating OTFTs with multilayer electrodes in accordance with the present disclosure. The examples are merely illustrative and are not intended to limit devices made in accordance with the disclosure to the materials, conditions, or process parameters set forth therein. All parts are percentages by volume unless otherwise indicated.

### EXAMPLES

### Example 1

A bottom-contact thin-film transistor with a configuration illustrated in Figure 1 was built. It comprised an n-doped silicon wafer with a thermally grown silicon oxide layer having a thickness of about 110 nanometers. The wafer functioned as the gate electrode. The silicon oxide layer functioned as the dielectric layer and had a capacitance of about 30 nanofarads per square centimeter (nF/cm²) as measured with a capacitor meter. The silicon wafer was first cleaned with isopropanol, air dried, and then immersed in a 0.1 M solution of octyltrichlorosilane (OTS8) in toluene for 20 minutes at 60°C. The wafer was subsequently washed with toluene and isopropanol and dried. A layer of copper with a thickness of about 60 nm was deposited on top of the silicon oxide dielectric layer by vacuum deposition through a shadow mask with various channel lengths and widths to create the first layer of the source and drain electrodes. Advanced water contact angles were measured to evaluate the surface energy of the OTS8 modified substrate and the first copper layer of the source and drain electrode. A water contact angle of 98 ± 2° was observed on OTS8 modified substrate, indicating a hydrophobic surface and a low surface energy. On the other hand, a water contact angle of 50± 2° was observed on the first copper layer, indicating a hydrophilic surface and a high surface energy. The substrates with the copper first layer were dipped into a water dispersion of 0.2 weight percent PSS-PEDOT , taken out slowly, and dried. Due to the difference in surface energy between the copper and OTS8 modified silicon oxide, a thin layer of PSS-PEDOT about 10-20 nanometers was coated only on the first copper layer to form the multilayer source and drain electrodes. The following polythiophene was used to fabricate the semiconductor layer

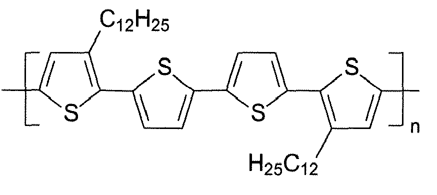

where n is a number of from about 5 to about 5,000. In this example, the polymer possessed an M_{w} of 22,900 and Mₙ of 17,300 relative to polystyrene standards. This polythiophene and its preparation are described in U.S. Patent Application Publication No. 2003/0160230, the disclosure of which is totally incorporated herein by reference. The semiconductor polythiophene layer of about 30 nanometers thick was deposited on top of the device by spin coating of the polythiophene in dichlorobenzene solution at a speed of 1,000 rpm for about 100 to about 120 seconds, and dried in vacuo at 80°C for about 2 to about 10 hours. The semiconductor layer was then heated to about 130°C to about 140°C for about 10 minutes to about 30 minutes.

The devices were characterized using a Keithley 4200 SCS semiconductor characterization system. Thin film transistors with channel lengths of 60 or 190 micron and channel widths of 1000 or 5000 microns were characterized by measuring their output and transfer curves. The device with the multilayer source and drain contacts turned on at around 0 volts with good saturation and provided field-effect mobility of 0.05 cm²/V.s and a current on/off ratio of 10⁵-10⁶. No contact resistance was observed in the output curves.

### Comparative Example 1

In this comparative example, the devices were fabricated using the same procedure as in Example 1 except that no second layer was used in the source and drain electrodes. Thin film transistors with channel lengths of 60 or 90 micron and channel widths of 1000 or 5000 microns were used for evaluation. The devices which have the copper layer only as the source and drain electrodes did not show any device performance. It could not be turned on even at the gate voltage of -60 V. This was due to high contact resistance between the copper electrode and the semiconductor layer.

While particular embodiments have been described, alternatives, modifications, variations, improvements, and substantial equivalents that are or may be presently unforeseen may arise to applicants or others skilled in the art. Accordingly, the appended claims as filed and as they may be amended are intended to embrace all such alternatives, modifications variations, improvements, and substantial equivalents.

## Claims

1. A thin-film transistor, comprising:
a source electrode;
a drain electrode; and
a semiconductor layer;
wherein the source electrode comprises a source electrode first layer and a source electrode second layer;
wherein the drain electrode comprises a drain electrode first layer and a drain electrode second layer; and
wherein the source electrode second layer is directly in contact with the semiconductor layer.

2. The thin-film transistor of **claim 1,** wherein the source electrode first layer and the drain electrode first layer are independently a metal.

3. The thin-film transistor of **claim 1,** wherein the source electrode second layer and the drain electrode second layer are independently a conductive polymer.

4. The thin-film transistor of **claim 3,** wherein the conductive polymer is selected from the group consisting of polyaniline, polypyrrole, PSS-PEDOT, their derivatives, and their mixtures.

5. The thin-film transistor of **claim 1,** wherein both the source electrode first layer and the drain electrode first layer are the same metal; and wherein both the source electrode second layer and the drain electrode second layer are the same conductive polymer.

6. The thin-film transistor of **claim 1,** wherein the source electrode first layer and the drain electrode first layer are independently selected from the group consisting of platinum, gold, silver, nickel, chromium, copper, iron, tin, antimony, lead, tantalum, indium, palladium, tellurium, rhenium, iridium, aluminum, ruthenium, germanium, molybdenum, tungsten, tin oxide-antimony, indium tin oxide, fluorine-doped zinc oxide, zinc, carbon, graphite, glassy carbon, silver paste, carbon paste, lithium, beryllium, sodium, magnesium, potassium, calcium, scandium, titanium, manganese, zirconium, gallium, niobium, sodium, sodium-potassium alloy, magnesium, and lithium.

7. The thin-film transistor of **claim 1,** wherein the source electrode first layer and the drain electrode first layer are independently selected from the group consisting of aluminum, copper, silver, nickel, chromium, iron, tin, antimony, lead, tantalum, indium, tungsten, tin oxide-antimony, indium tin oxide, fluorine-doped zinc oxide, zinc, carbon, graphite, silver paste, and carbon paste.

8. The thin-film transistor of **claim 1,** wherein the source electrode first layer and the drain electrode first layer each have a thickness of from about 10 nanometers to about 1000 nanometers.

9. An organic thin-film transistor, comprising:
a source electrode;
a drain electrode; and
an organic semiconductor layer;
wherein the source electrode comprises a source electrode first layer and a source electrode second layer;
wherein the drain electrode comprises a drain electrode first layer and a drain electrode second layer;
wherein both the source electrode first layer and the drain electrode first layer are independently selected from the group consisting of copper, silver, chromium, aluminum, tin oxide-antimony, indium tin oxide, silver paste, carbon paste, and mixtures thereof;
wherein both the source electrode second layer and the drain electrode second layer are a conductive polymer; and
wherein the source electrode second layer is in contact with the organic semiconductor layer.

10. A process for making a multilayer electrode comprising:
selecting a surface and a metal so that the metal has a higher surface energy than the surface;
depositing the metal upon the surface to form a first electrode layer;
coating the surface having the first electrode layer with a water dispersion of a conductive polymer to form a second electrode layer upon the first electrode layer;
optionally drying the first and the second electrode layers to form a multilayer electrode.
